Europäisches Patentamt

European Patent Office

Office européen des brevets

(19)

(11) **EP 1 251 634 A1**

(12) **DEMANDE DE BREVET EUROPEEN**

(43) Date de publication:
**23.10.2002 Bulletin 2002/43**

(51) Int Cl.$^7$: **H03F 1/32**

(21) Numéro de dépôt: **02290982.4**

(22) Date de dépôt: **18.04.2002**

(84) Etats contractants désignés:
**AT BE CH CY DE DK ES FI FR GB GR IE IT LI LU MC NL PT SE TR**
Etats d'extension désignés:
**AL LT LV MK RO SI**

(30) Priorité: **20.04.2001 FR 0105369**

(71) Demandeur: **STMicroelectronics S.A.**
**92120 Montrouge (FR)**

(72) Inventeurs:
• **Pellat, Bruno**
**53190 Laval (FR)**
• **Grasset, Jean-Charles**
**38430 Moirans (FR)**

(74) Mandataire: **Weber, Etienne Nicolas et al**
**c/o Brevalex,**
**3, rue du Docteur Lancereaux**
**75008 Paris (FR)**

(54) **Etage de transconductance et dispositif de communication par voie hertzienne equipé d'un tel étage**

(57)    Un étage de transconductance pour téléphones portables comprenant :

- au moins un transistor bipolaire principal (110), le transistor bipolaire principal présentant une base reliée à une borne d'entrée (112), un collecteur relié à une borne de sortie (114), et un émetteur relié à une borne d'alimentation (116) par l'intermédiaire d'une résistance de dégénérescence (120),
- au moins un transistor bipolaire de compensation (130), connecté en parallèle au transistor principal et relié sans résistance de dégénérescence à la borne d'alimentation (116),

dans lequel la valeur $R_E$ de la résistance de dégénérescence est choisie telle que

$$R_E * I_0 > V_T/2$$

où $V_T$ est la tension thermique et $I_0$ le courant de repos du transistor principal.

Fig. 3A

**Description**

Domaine technique.

La présente invention concerne un étage de transconductance à linéarité améliorée. Elle concerne de façon plus précise un tel étage présentant une faible distorsion et dont la sortie est affranchie de composantes parasites liées à des produits d'intermodulation du troisième ordre.
L'invention trouve des applications dans la réalisation d'émetteurs ou de récepteurs, et en particulier dans la réalisation d'équipements de communication tels que des téléphones portables.

Etat de la technique antérieur.

Un étage de transconductance, encore appelé "transconducteur" est un dispositif électronique capable de convertir une tension d'entrée en un courant de sortie. La tension peut être une tension référencée par rapport à un potentiel ou une tension différentielle. De la même façon, le courant peut être un courant différentiel ou non.

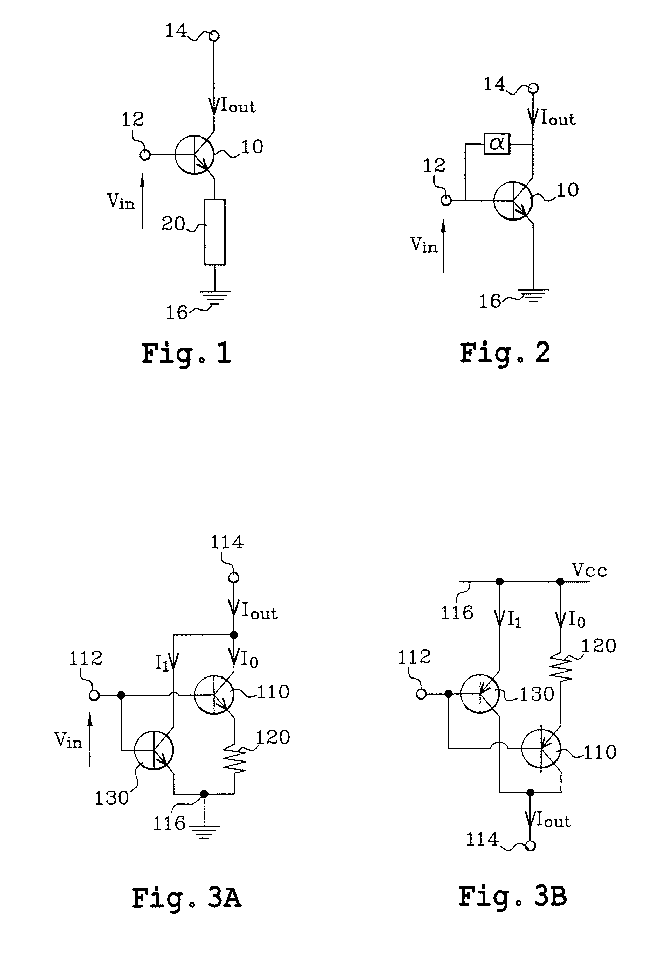

La figure 1 des dessins annexés montre une réalisation possible d'un étage de transconductance très simple réalisé autour d'un transistor bipolaire 10. Une tension Vin est appliquée à la base du transistor tandis qu'un courant $I_{out}$ circule dans une branche de circuit reliée au collecteur en une borne de sortie 14. L'émetteur du transistor est relié à une borne d'alimentation 16, et en l'occurrence à la borne de masse, par l'intermédiaire d'une résistance ou plus généralement une impédance de dégénérescence 20.
En désignant par v les variations de la tension de la base du transistor et par i les variations du courant de collecteur qu'elles engendrent, l'étage transconducteur de la figure 1 présente une transconductance équivalente $gm_{eq}$ telle que :

$$gm_{eq} = \frac{i}{v} = \frac{gm}{1 + gm \cdot Ze} \qquad (1)$$

Dans cette expression gm désigne la transconductance du transistor isolé, en l'absence de résistance de dégénérescence. Celle-ci est telle que :

$$gm = I_0 / V_T \qquad (2)$$

$I_0$ est le courant de repos du transistor et $V_T$ la tension thermodynamique.
On rappelle que la tension thermodynamique $V_T$ est telle que $V_T = kT/q$ où T est la température absolue de fonctionnement (exprimée en Kelvin), k la constante de Boltzmann, et q la charge de l'électron.
Lorsque l'étage de transconductance est relié par son collecteur à une impédance de charge de valeur $Z_{out}$, c'est-à-dire par la borne 14 de la figure, on obtient un gain en tension Gv tel que :

$$Gv = gm_{eq} * Z_{out} \qquad (3)$$

Dans un dispositif de réception ou d'émission, l'étage de transconductance transmet les composantes en fréquence d'un signal qui lui est appliqué, mais aussi d'autres composantes parmi lesquelles les composantes dites de produit d'intermodulation. Ces composantes, générées par l'étage de transconductance, sont dues notamment à un défaut de linéarité.
A titre d'illustration, si un signal reçu par l'étage comprend deux composantes en fréquence notées $F_1$ et $F_2$, le signal de sortie comprend les composantes fondamentales $F_1$ et $F_2$, et aussi leurs harmoniques $2F_1$, $2F_2$, $3F_1$, $3F_2$, etc., des composantes d'intermodulation du second ordre, du type $F_1 - F_2$ et $F_1 + F_2$, ainsi que des composantes d'intermodulation du troisième ordre, du type $2F_1 - F_2$ ou $2F_2 - F_1$, par exemple.
Les composantes de produits d'intermodulation, qui sont des composantes parasites du signal de sortie, présentent généralement des amplitudes faibles par rapport aux composantes des fréquences dont elles dérivent.
Elles sont toutefois gênantes lorsque leur fréquence coïncide avec celle de la bande du signal utile.
Par exemple, une composante de fréquence F de faible amplitude risque d'être en concurrence avec une composante parasite du type $2F_1 - F_2$ identique.
Si $F - F_2 = F_2 - F_1$, ces difficultés apparaissent tout particulièrement dans des domaines tels que celui des télécommunications par voie hertzienne, où certains canaux, dont la réception est très faible, risquent d'être perturbés par des canaux voisins forts.

Afin d'augmenter la linéarité des étages de transconductance, et donc réduire l'amplitude des composantes parasites susceptibles d'être générées, on équipe les étages de moyens de contre-réaction.

Les moyens de contre-réaction consistent, par exemple, en une résistance de dégénérescence d'émetteur telle que la résistance 20 décrite en relation avec la figure 1. Une valeur de résistance plus forte améliore la linéarité de l'étage.

En revanche, le gain en linéarité est obtenu au prix d'une transconductance équivalente ou d'un gain en tension plus faible. On peut se reporter à ce sujet aux équations (1) et (3) indiquées précédemment.

Ainsi, pour obtenir un signal de sortie de même amplitude que celui qui serait obtenu sans les moyens de contre réaction, il faut augmenter la puissance d'alimentation. Ceci revient à augmenter le courant de repos traversant le transistor ou la tension d'alimentation.

Or, il s'avère que pour des équipements de communication portables, tels que les téléphones cellulaires fonctionnant sur une source d'énergie portable, par exemple un accumulateur électrique, une consommation accrue en énergie a une influence très négative sur l'autonomie.

Une autre possibilité de contre-réaction visant à améliorer la linéarité d'un étage de transconductance est illustrée par la figure 2.

La figure 2 montre un étage de transconductance construit autour d'un transistor 10 associé à une branche de contre réaction parallèle 22 connectée entre le collecteur et la base. Les bornes d'entrée 12 et de sortie 14 correspondent, comme pour le dispositif de la figure 1 à la base et au collecteur. L'émetteur est directement relié à une borne d'alimentation 16 (masse).

Une branche de contre-réaction 22, connectée entre les bornes d'entrée et de sortie, permet de soustraire à la tension d'entrée une fraction $\alpha$ de la tension de sortie. La transconductance équivalente $gm_{eq}$ de l'étage de la figure 2 se trouve réduite.

Une augmentation de la proportion de contre-réaction $\alpha$ conduit à une meilleure linéarité mais aussi à une plus faible transconductance équivalente.

Ainsi, comme pour le dispositif de la figure 1, l'augmentation de la linéarité est au prix d'une plus forte consommation électrique.

On connaît également par le document (1), dont la référence complète est précisée à la fin de la description, un transconducteur fonctionnant en classe AB, et non en classe A, comme les étages des figures 1 et 2.

Le dispositif décrit dans le document (1) présente l'avantage de réduire les composantes de troisième ordre du produit d'intermodulation dans des proportions importantes. Cependant, une structure de base commune confère au dispositif une impédance d'entrée très faible. Ainsi, des moyens d'adaptation de l'impédance à une valeur de 50Ω, usuelle pour les émetteurs récepteurs à haute fréquence, auraient pour conséquence de réduire fortement la transconductance par rapport à un montage du même type des figures 1 et 2 auquel on aurait appliqué la même adaptation d'impédance (car on tire profit dans ce cas de l'impédance naturellement élevée du montage).

Exposé de l'invention

L'invention a pour but de proposer un étage de transconductance qui ne présente pas les limitations des dispositifs décrits précédemment.

Un but est en particulier de proposer un tel étage de transconductance présentant une bonne linéarité et une faible distorsion, libre des composantes de produit d'intermodulation du troisième ordre et une transconductance élevée.

Un autre but est aussi de proposer un tel étage de transconductance qui présente une faible consommation en énergie.

L'invention a encore pour but de proposer un tel étage avec une influence réduite de composantes d'intermodulation du troisième ordre.

Un but supplémentaire de l'invention est de proposer un étage de transconductance avec une impédance d'entrée susceptible d'être aisément adaptée à une valeur voisine de 50 Ω.

Pour atteindre ces buts l'invention a plus précisément pour objet un étage de transconductance comprenant :

- au moins un transistor bipolaire principal, le transistor bipolaire principal présentant une base reliée à une borne d'entrée, un collecteur relié à une borne de sortie, et un émetteur relié à une borne d'alimentation par l'intermédiaire d'une résistance de dégénérescence,
- au moins un transistor bipolaire de compensation, connecté en parallèle au transistor principal et relié sans résistance de dégénérescence à la borne d'alimentation,

dans lequel la valeur $R_E$ de la résistance de dégénérescence du transistor principal est choisie telle que

$$R_E * I_0 > V_T/2$$

où $V_T$ est la tension thermodynamique et $I_0$ le courant de repos du transistor principal.

Le choix de la résistance de dégénérescence $R_E$ est effectué de préférence tel que :

$R_E \gg V_T/2I_0$ soit, par exemple,
$R_E > 10V_T/2I_0$.

On considère, au sens de l'invention, que le transistor de compensation est dépourvu de résistance de dégénérescence lorsque la résistance électrique de la liaison en l'émetteur de ce transistor à la borne d'alimentation est suffisamment faible pour être négligée par comparaison avec la résistance de dégénérescence du transistor principal. En d'autres termes, en désignant par r la valeur d'une éventuelle résistance de dégénérescence du transistor de compensation, la valeur r devrait être telle que $r \ll V_T/2I'_0$. $I'_0$ est le courant de repos du transistor de compensation.

Par ailleurs on entend par borne d'alimentation une borne utilisée pour la polarisation des transistors, c'est-à-dire pour la fixation de leurs courants de repos. La borne d'alimentation peut être une borne au potentiel d'une source d'alimentation, par exemple, ou une borne de masse.

En respectant la condition de choix de la résistance de dégénérescence du transistor principal indiquée ci-dessus, la phase des composantes de produit d'intermodulation du troisième ordre, générées par le transistor principal et le transistor de compensation, sont de signes opposés et se soustraient mutuellement. L'amplitude résultante des composantes du troisième ordre est donc inférieure à celle des composantes du troisième ordre qu'auraient généré chacun des transistors pris individuellement.

Une polarisation appropriée du transistor de compensation, et un ajustage de son courant de repos, permettent de générer avec ce transistor des harmoniques de troisième ordre qui sont de plus égales en amplitude à celles générées par le transistor principal. Dans ce cas, les harmoniques de troisième ordre des deux transistors non seulement se soustraient mais s'annulent.

Selon une réalisation particulière de l'étage de transconductance, celui-ci peut comporter en outre une inductance reliant le transistor principal et le transistor de compensation à la borne d'alimentation. L'inductance est connectée en série avec la résistance de dégénérescence entre l'émetteur du transistor principal et la borne d'alimentation.

Cette inductance augmente l'impédance d'entrée de l'étage. Sa valeur peut-être choisie en fonction de l'impédance d'entrée que l'on souhaite obtenir, de façon à mieux ajuster cette impédance sur la valeur usuelle de $50\Omega$. Une adaptation d'impédance peut bien sûr être réalisée en associant à la base du transistor une résistance ou d'autres composants passifs appropriés.

Selon un perfectionnement de l'invention, l'étage de transconductance peut comporter en outre une inductance dite inductance parallèle connectée en parallèle à la résistance de dégénérescence du transistor principal. L'inductance parallèle présente une valeur $L_E$ telle que :

$$L_E \ll R_E/2\Pi\Delta F$$

et

$$L_E \gg R_E/2\Pi F,$$

F étant une fréquence de travail centrale de l'étage de transconductance et $\Delta F$ la largeur d'une bande de fréquences susceptible de contenir des composantes d'un produit d'intermodulation du troisième ordre généré par l'étage.

La première condition indiquée pour le choix de la valeur de l'inductance parallèle permet, d'une part, à l'inductance de se comporter comme un court-circuit vers la borne d'alimentation pour filtrer les composantes de fréquence dont la valeur correspond à la bande de fréquence $\Delta F$ choisie. Ces fréquences correspondent à des composantes d'intermodulation d'ordre 2, du type $F_1-F_2$ ou $F_2-F_1$, pour se reporter à l'exemple choisi dans la partie introductive de la description.

Les composantes d'intermodulation d'ordre 2, se combinent en effet avec les composantes fondamentales pour générer de nouvelles composantes d'ordre 3. Le filtrage réalisé par l'inductance parallèle permet de limiter ou d'éliminer ce phénomène.

La deuxième condition sur le choix de la valeur $L_E$ de l'inductance parallèle permet de conférer à l'inductance une impédance très supérieure à celle de la résistance de dégénérescence de sorte qu'elle ne perturbe pas la valeur de cette résistance aux fréquences de fonctionnement autour de la valeur F.

L'étage de transconductance de l'invention peut être un étage simple ou un étage différentiel.

Dans ce deuxième cas, il comporte un premier et un deuxième transistors principaux et un premier et un deuxième transistors de compensation connectés respectivement en parallèle aux premier et deuxième transistors principaux. Les bases des premier et deuxième transistors principaux sont respectivement reliées à une première et une deuxième bornes d'entrée formant une entrée différentielle, les collecteurs des premier et deuxième transistors principaux sont respectivement reliés à une première et une deuxième bornes de sortie, et les émetteurs des premier et deuxième transistors principaux sont respectivement reliés à une borne d'alimentation par l'intermédiaire d'une première et une deuxième résistance de dégénérescence. Par ailleurs, les premier et deuxième transistors de compensation sont reliés sans résistance de dégénérescence à la borne d'alimentation. Les première et deuxième résistances de dégénérescence des transistors principaux présentent des valeurs $R_{E1}$ et $R_{E2}$ telles que :

$$R_{E1*}I_1 > V_T/2$$

et

$$R_{E2*}I_2 > V_T/2$$

où les termes $I_1$ et $I_2$ désignent les courants de repos des premier et deuxième transistors principaux et où $V_T$ désigne la tension thermodynamique.

Les critères de sélection des résistances de dégénérescence pour chaque partie de l'étage différentiel sont les mêmes que pour l'étage simple décrit précédemment.

De préférence, on a :

$$R_{E1}.I_1 >> V_T/2$$

et

$$R_{E2}.I_2 >> V_T/2.$$

De la même façon, l'étage de transconductance peut être équipé d'inductances destinées à faciliter l'adaptation d'impédance des entrées. L'étage de transconductance comporte alors une première et une deuxième inductances reliant respectivement les premier et deuxième transistors principaux et de compensation à la borne d'alimentation. Les première et deuxième inductances sont connectées en série avec les première et deuxième résistances de dégénérescence entre les émetteurs des transistors principaux et la borne d'alimentation.

Enfin, l'étage de transconductance peut comporter une inductance de valeur L connectée entre les émetteurs des transistors principaux.

La valeur de cette inductance est choisie de manière à présenter une impédance élevée pour des composantes du signal correspondant sensiblement à la fréquence de travail, de manière à ne pas perturber le fonctionnement pour ces fréquences. Elle est également choisie de manière à présenter une impédance faible pour les composantes de produit d'intermodulation du deuxième ordre de façon à les filtrer.

En considérant que les résistances de dégénérescence du premier et du deuxième transistor principal sont égales toutes deux à la même valeur $R_E$, L peut être choisi tel que :

$$\frac{L}{2} \cdot 2\pi \cdot \Delta F \ll R_E$$

et

$$\frac{L}{2} \cdot 2\pi \cdot F \gg R_E$$

Les valeurs $\Delta F$ et F sont les mêmes que celles déjà considérées précédemment.

L'invention concerne non seulement un étage de transconductance mais aussi un étage d'émission ou de réception comprenant entre une antenne et un modulateur ou un démodulateur, un amplificateur à faible bruit et un dispositif de transposition de fréquence équipé d'un mélangeur, dans lequel au moins l'un des mélangeur et amplificateur comporte un étage de transconductance conforme à la revendication 1.

Enfin l'invention concerne l'utilisation d'un étage de transconductance tel que décrit dans un téléphone portable.

D'autres caractéristiques et avantages de l'invention ressortiront de la description qui va suivre. Celle-ci est donnée à titre purement illustratif et non limitatif.

Brève description des figures.

- La figure 1, déjà décrite, est un schéma d'un étage de transconductance à contre-réaction série, d'un type connu.
- La figure 2, déjà décrite, est un schéma d'un étage de transconductance à contre-réaction parallèle, d'un type également connu.
- Les figures 3A et 3B sont des schémas d'un étage de transconductance simple, conforme à la présente invention.
- La figure 4 est un schéma d'un étage de transconductance différentiel, conforme à la présente invention.
- La figure 5 et la figure 6 sont des schémas d'étages de transconductances correspondant à un perfectionnement des étages des figures 3A et 4.
- La figure 7 et la figure 8 sont des schémas d'étages de transconductance correspondant à un autre perfectionnement des étages des figures 3A et 4.
- Les figures 9A et 9B sont des représentations schématiques simplifiées d'un récepteur et d'un émetteur hertzien équipé d'un étage de transconductance conforme à l'invention.

Description détaillée de modes de mise en oeuvre de l'invention.

Dans la description qui suit, des éléments identiques, équivalents ou similaires des différentes figures sont repérés avec les mêmes références numériques.

L'étage de transconductance de la figure 3A comprend un premier transistor 110, désigné par transistor principal, et un deuxième transistor 130, dit transistor de compensation, connecté en parallèle sur le transistor principal. Bien que ce ne soit pas une condition nécessaire au fonctionnement de l'étage, les deux transistors présentent de préférence les mêmes caractéristiques.

La base des transistors est connectée à une borne d'entrée 112 à laquelle est appliquée une tension d'entrée Vin. Les collecteurs des transistors sont reliés à une borne de sortie 114 à laquelle peut éventuellement être reliée une charge de l'étage, non représentée. Le courant qui traverse cette charge est désigné par $I_{out}$. Les courants de repos du transistor de compensation et du transistor principal sont notés respectivement $I_1$ et $I_0$. Ces courants sont fixés par les caractéristiques des transistors et éventuellement par des résistances de polarisation non représentées.

Les émetteurs des transistors sont reliés à une borne d'alimentation 116 qui, sur cette figure, correspond au potentiel de masse. L'émetteur du transistor de compensation est directement relié à la borne d'alimentation de sorte qu'il ne soit pas dégénéré. En revanche, l'émetteur du transistor principal est relié à la borne d'alimentation par l'intermédiaire d'une résistance de dégénérescence 120, de valeur $R_E$. Il convient de préciser que la résistance 120 peut être formée d'un composant résistif unique ou comporter plusieurs composants résistifs.

Comme évoqué précédemment, la valeur de la résistance $R_E$ est choisie telle que $R_E * I_0$ soit supérieur $V_T/2$ et même très supérieur.

Les inventeurs ont observé en effet que la phase de l'harmonique du produit d'intermodulation du troisième ordre, en ce qui concerne le transistor principal, dépend de la valeur de la résistance de dégénérescence, et que cette phase s'inverse autour d'une valeur de $R_E$ qui est justement $V_T/2I_0$.

A titre d'illustration, si la phase de l'harmonique du troisième ordre est de 180° pour une valeur nulle ou sensiblement nulle de la résistance de dégénérescence, elle est de 90° pour une valeur de $R_E=V_T/2I_0$ et est nulle (=0°) pour une valeur de $R_E$ grande devant $V_T/2I_0$. Ainsi, le cas d'une phase égale à 180° correspond au transistor de compensation dont l'émetteur n'est pas dégénéré tandis que le cas d'une phase de 0° correspond au transistor principal.

Les phases des composantes des produits d'intermodulation du troisième ordre étant opposées, ces composantes, provenant du transistor principal et du transistor de compensation, se soustraient. Lorsque l'amplitude des composantes du troisième ordre est sensiblement la même pour les deux transistors, la compensation peut aller jusqu'à l'élimination complète de ces composantes. Ce cas idéal peut être approché, par exemple, en utilisant des transistors aux caractéristiques sensiblement identiques et en ajustant le courant de repos $I_1$ du transistor de compensation.

Le tableau I, ci-dessous, donne à titre de comparaison, les amplitudes de sortie d'un signal utile à une fréquence de 2GHz, et l'amplitude mesurée en dBc relativement à l'amplitude du fondamental, notée Imd3, des composantes de produits d'intermodulation du troisième ordre pour, d'une part, un étage de transconductance conforme à la figure 1 de l'art antérieur, et, d'autre part, pour un étage de transconductance conforme à l'invention et à la figure 3A. Dans les deux cas, le décalage de fréquence de la composante de produits d'intermodulation du troisième ordre est de $\Delta F=1MHz$, la tension d'entrée $V_{in}$ est de 10mV, et la valeur de la résistance de dégénérescence est de $20\Omega$.

Tableau I

| Caractéristique/ performance | Art antérieur/ Fig 1 | Invention/ Fig 3A |
|---|---|---|
| Résistance de dégénérescence | $R_E=20\Omega$ | $R_E=20\Omega$ |
| Courant de repos | $I_0=2,947mA$ | $I_0=2,947mA$ $I_1=26,8\ \mu A$ |
| $I_{out}$ | -69,59dBI | -69,28dBI |
| Imd3 (atténuation) | -65,64dBc | -103,0dBc |

On constate, à la lecture du tableau I, que pour des courants de repos sensiblement identiques (à $26,8\mu A$ près), c'est-à-dire pour des consommations électriques sensiblement identiques, les composantes de produits d'intermodulation subissent une très forte atténuation dans l'étage de transconductance conforme à l'invention (-103dB au lieu de -65dB).

A titre de comparaison, pour obtenir une atténuation aussi forte avec l'étage de transconductance de l'art antérieur, la valeur $R_E$ aurait dû être augmentée à 27,5 $\Omega$ et le courant de repos $I_0$ de la résistance de dégénérescence aurait dû être augmenté à 14,8 mA. Ces mesures auraient donc conduit à une forte augmentation de la consommation d'énergie électrique.

La figure 3A illustre une réalisation d'un étage conforme à l'invention, construit autour de transistors de type NPN. Un étage sensiblement identique peut être réalisé, comme le montre la figure 3B, à partir de transistors PNP. La borne de sortie 114 reste celle reliée aux collecteurs des transistors. En revanche, la borne d'alimentation 116, n'est plus la borne de masse comme dans l'exemple précédent, mais est une borne d'alimentation à un potentiel $V_{CC}$ positif par rapport à la masse.

Pour le reste, et notamment pour le choix de la résistance de dégénérescence, on peut se reporter à la description relative à la figure 3A.

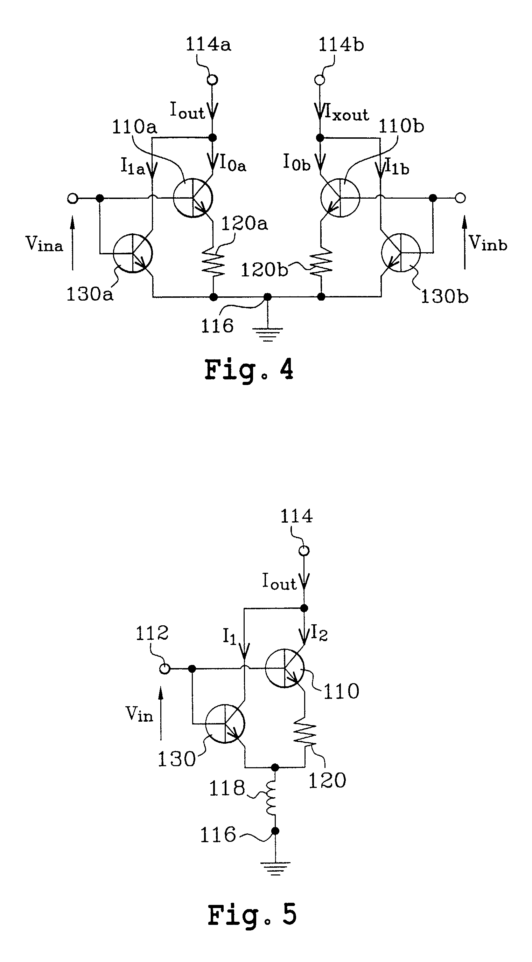

La figure 4 montre une autre possibilité de réalisation d'un étage de transconductance conforme à l'invention. Il s'agit d'un étage différentiel. Deux transistors principaux 110a et 110b, à dégénérescence d'émetteur sont associés à deux transistors de compensation 130a, 130b, non dégénérés, connectés respectivement en parallèle aux transistors principaux. Les transistors peuvent être identiques ou différents. L'étage différentiel se présente comme l'association de deux étages simples conformes à la figure 3A, (ou 3B). Ainsi, les caractéristiques qui correspondent à celles du dispositif de la figure 3A, ne sont pas entièrement décrites ici. Les valeurs $R_{Ea}$ et $R_{Eb}$ des résistances de dégénérescence 120a, 120b connectées aux émetteurs des transistors principaux peuvent être identiques ou différentes. Elles sont cependant toutes deux choisies selon le critère indiqué précédemment c'est-à-dire supérieures et de préférence très supérieures à $V_T/2I_0a$ ou à $V_T/2I_0b$ où $I_0a$ et $I_0b$ sont les courants de repos du transistor principal considéré.

L'étage de transconductance présente deux bornes de sortie 114a et 114b qui délivrent des courants de sortie $I_{out}$ et $I_{xout}$. Il convient de ne pas confondre ces courants dynamiques avec les courants $I_1a$, $I_1b$, $I_0a$ et $I_0b$ indiqués sur la figure. Les courants $I_1a$, $I_1b$, $I_0a$ et $I_0b$ sont les courants de repos des transistors principaux et de compensation.

L'entrée de l'étage comprend deux bornes d'entrée qui sont, sur la figure 4, les bornes 112a et 112b. Ces bornes reçoivent des tensions d'entrée Vina et Vinb.

Bien qu'il ne soit pas décrit de façon détaillée ici, l'étage de transconductance symétrique peut également être réalisé à partir de transistors PNP. On peut se reporter à ce sujet à la figure 3B et à la description correspondante.

Lorsque l'étage de transconductance doit être utilisé dans un émetteur ou un récepteur hertzien, son entrée est adaptée à une impédance réelle de l'ordre de $50\Omega$. L'adaptation d'impédance peut avoir lieu, par exemple par la mise en série avec l'entrée de l'étage d'une résistance appropriée. Or, l'étage de transconductance conforme à l'une des figures 3A, 3B ou 4 s'avère toutefois présenter, en l'absence d'adaptation particulière, une impédance résistive relativement faible. Celle-ci rend plus difficile l'adaptation à $50\Omega$.

La figure 5 montre un perfectionnement de l'étage de transconductance de la figure 3A, permettant, sans insérer de résistance supplémentaire, d'augmenter la valeur résistive de son l'impédance d'entrée en haute fréquence. Conformément à la réalisation illustrée par la figure 5, une inductance 118, de valeur L, est insérée entre l'émetteur du transistor de compensation et la borne d'alimentation 116. L'inductance est également reliée à l'émetteur du transistor principal, par l'intermédiaire de la résistance de dégénérescence 120. Elle se trouve ainsi en série avec cette résistance entre l'émetteur du transistor principal et la borne d'alimentation.

La valeur de l'inductance 118 peut être choisie, par exemple, en fonction d'une pulsation de transition de l'étage, et de telle sorte que la partie réelle de l'impédance d'entrée soit de l'ordre de 50 Ω. A titre d'exemple, on peut choisir une valeur de 0,8 nH.

Le tableau II ci-dessous montre l'influence de l'inductance 118 dans l'étage de transconductance de la figure 5, par comparaison avec celui de la figure 3A.

Tableau II

| Caractéristiques | Fig 3A (sans self 118) | Fig 5 (avec self 118) |
|---|---|---|
| $I_1$ | 400µA | 400µA |
| $I_0$ | 5mA | 5mA |
| $R_E$ | 5Ω | 5Ω |
| L (self 118) | Sans (0nH) | 1nH |
| Impédance d'entrée à 2 GHz | 9-66j | 80-63j |

Dans ce tableau, $I_1$, $I_0$, $R_E$ et L désignent respectivement le courant de repos du transistor de compensation 130, celui du transistor principal 110, la valeur de la résistance de dégénérescence 120, et la valeur de l'inductance 118. On constate que la partie réelle de l'impédance d'entrée est largement améliorée.

La figure 6 montre l'utilisation d'inductances d'adaptation d'impédance dans un étage différentiel. On observe que les résistances de dégénérescence des deux transistors principaux ne sont plus reliées entre-elles à la borne d'alimentation 116, mais sont chacune reliées à la borne d'alimentation 116 par une inductance d'adaptation d'impédance. Ces inductances, repérées par les références 118a, et 118b sont respectivement en série avec les résistances de dégénérescence entre les émetteurs des transistors principaux et la borne d'alimentation. Elles sont par ailleurs reliées directement aux émetteurs des transistors de compensation.

Comme évoqué dans la partie introductive du texte, le signal comprend non seulement des produits d'intermodulation du troisième ordre mais aussi des produits d'intermodulation du deuxième ordre. Ceux-ci, combinés aux composantes fondamentales sont susceptibles de générer des composantes supplémentaires du troisième ordre.

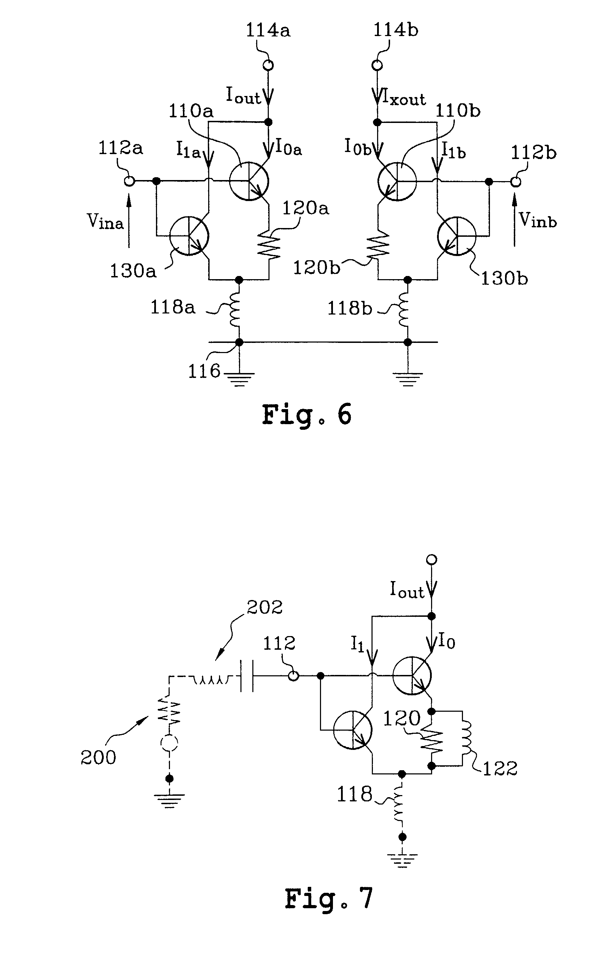

La figure 7 montre un perfectionnement de l'étage de transconductance de l'invention qui vise essentiellement à éliminer ou réduire les composantes du deuxième ordre, partant, celles du troisième.

L'étage de la figure 7 comprend les composants de la figure 5 auxquels se rajoute une inductance 122 connectée en parallèle aux bornes de la résistance de dégénérescence 120. On considère, de façon générale, que l'inductance parallèle 122 est connectée en parallèle à la résistance de dégénérescence 120, lorsqu'elle est connectée en parallèle à tout ou partie de cette résistance.

La valeur $L_E$ de l'inductance parallèle 122 est choisie de telle sorte qu'elle soit transparente, c'est-à-dire qu'elle présente une impédance très grande pour les composantes correspondant aux fréquences F fondamentales du signal utile. Elle est également choisie pour filtrer, c'est-à-dire présenter une impédance faible pour une bande de fréquence ΔF correspondant à l'intermodulation du deuxième ordre. Les ordres de grandeur des fréquences F et ΔF sont très différents. Les fréquences F fondamentales du signal utile sont de l'ordre de 1GHz, par exemple, tandis que les fréquences d'intermodulation ΔF (i.e., par ex. $F_2$-$F_1$) sont de l'ordre de 1 MHz.

Comme indiqué précédemment, l'inductance parallèle 122 est ainsi choisie de telle sorte que :

$$L_E << R_E/2\pi\Delta F$$

et

$$L_E >> R_E/2\pi F.$$

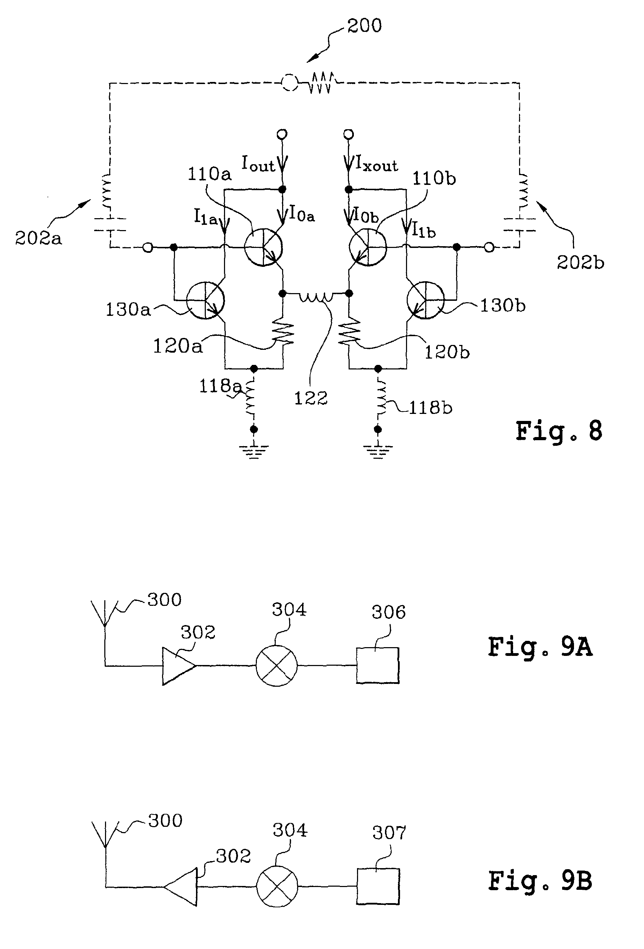

La figure 8 montre l'application de ce perfectionnement à un étage de transconductance différentiel conforme à la figure 6. Une inductance 122 est connectée entre les émetteurs des transistors principaux 110a et 110b. La valeur de cette inductance est déterminée sur les mêmes critères que ceux évoqués ci-dessus.

Les inductances d'adaptation d'impédance 118, 118a et 118b sont représentée en trait discontinu sur les figures 7 et 8. Bien qu'elles constituent une amélioration, elles ne sont pas indispensables. Par ailleurs, on a également représenté les sources de tension 200 et des composants 202, 202a et 202b d'adaptation d'impédance, reliées aux

**EP 1 251 634 A1**

bornes d'entrée des étages des figures 7 et 8. Les composants d'adaptation d'impédance comportent une inductance et/ou une capacité en série. Ils sont également représentés en trait discontinu, car facultatifs.

Les figures 9A et 9B indiquent les principaux éléments respectivement d'un étage de réception et d'un étage d'émission d'un téléphone portable ou d'un autre dispositif de communication. Il s'agit en particulier d'une antenne 300, d'un amplificateur 302, d'un mélangeur 304 et d'un démodulateur 306 (fig.9A) ou un modulateur 307 (fig.9B). Le mélangeur 304, associé à un oscillateur local, non représenté, fait partie d'un dispositif de transposition de fréquence. Un étage de transconductance conforme à l'invention et tel que décrit précédemment, peut être utilisé notamment dans le mélangeur 304 ou dans l'amplificateur 302, comme étage d'entrée, par exemple.

**Document cité.**

**(1)**

US-A-5 826 182

**Revendications**

1. Etage de transconductance comprenant :

   - au moins un transistor bipolaire principal (110, 110a, 110b), le transistor bipolaire principal présentant une base reliée à une borne d'entrée (112, 112a, 112b), un collecteur relié à une borne de sortie (114, 114a, 114b), et un émetteur relié à une borne d'alimentation (116) par l'intermédiaire d'une résistance de dégénérescence (120, 120a, 120b),
   - au moins un transistor bipolaire de compensation (130, 130a, 130b), connecté en parallèle au transistor principal et relié sans résistance de dégénérescence à la borne d'alimentation,

   dans lequel la valeur $R_E$ de la résistance de dégénérescence est choisie telle que

   $$R_E * I_0 > V_T/2$$

   où $V_T$ est la tension thermique et $I_0$ le courant de repos du transistor principal.

2. Etage de transconductance selon la revendication 1, dans lequel

   $$R_E{}_*I_O > 10 V_T/2.$$

3. Etage de transconductance selon la revendication 1, comprenant en outre une inductance (118, 118a, 118b) reliant le transistor principal et le transistor de compensation à la borne d'alimentation, l'inductance étant connectée en série avec la résistance de dégénérescence entre l'émetteur du transistor principal et la borne d'alimentation.

4. Etage de transconductance selon la revendication 1, comprenant en outre une inductance (122) dite inductance parallèle connectée en parallèle à la résistance de dégénérescence, l'inductance présentant une valeur $L_E$ telle que :

   $$L_E << R_E/2\Pi\Delta F$$

   et

   $$L_E >> R_E/2\Pi F,$$

   F étant une fréquence de travail centrale de l'étage de transconductance et $\Delta F$ la largeur d'une bande de fréquences susceptible de contenir des composantes d'un produit d'intermodulation de troisième ordre généré par l'étage

**5.** Etage de transconductance différentiel selon la revendication 1, comprenant un premier et un deuxième transistors principaux (110a, 110b) et un premier et un deuxième transistors de compensation (130a, 130b) connectés respectivement en parallèle aux premier et deuxième transistors principaux, les bases des premier et deuxième transistors principaux étant respectivement reliées à une première et une deuxième bornes d'entrée (112a, 112b) formant une entrée différentielle, les collecteurs des premier et deuxième transistors principaux étant respectivement reliés à une première et une deuxième bornes de sortie (114a, 114b), et les émetteurs des premier et deuxième transistors principaux étant respectivement reliés à une borne d'alimentation (116) par l'intermédiaire d'une première et une deuxième résistances de dégénérescence (120a, 120b), les premier et deuxième transistors de compensation étant reliés sans résistance de dégénérescence à la borne d'alimentation, et les première et deuxième résistances de dégénérescence présentant des valeurs $R_{E1}$ et $R_{E2}$ telles que :

$$R_{E1*}I_1>V_T/2$$

et

$$R_{E2*}I_0>V_T/2$$

où les termes $I_1$ et $I_0$ désignent les courants de repos des premier et deuxième transistors principaux et où $V_T$ désigne la tension thermodynamique.

**6.** Etage de transconductance selon la revendication 5, comprenant en outre une première et une deuxième inductances (118a, 118b) reliant respectivement les premiers et deuxièmes transistors principaux (110a, 110b) et de compensation à la borne d'alimentation, les première et une deuxième inductances étant connectées en série avec les première et deuxième résistances de dégénérescence entre les émetteurs des transistors principaux et la borne d'alimentation.

**7.** Etage de transconductance selon la revendication 5, comprenant en outre une inductance (122) connectée entre les émetteurs des transistors principaux (110a, 110b).

**8.** Récepteur hertzien comprenant entre une antenne de réception (300) et un démodulateur (306), un amplificateur à faible bruit (302) et un dispositif de transposition de fréquence équipé d'un mélangeur (304), dans lequel au moins l'un des mélangeur et amplificateur comporte un étage de transconductance conforme à la revendication 1.

**9.** Emetteur hertzien comprenant entre une antenne de réception (300) et un modulateur (307), un amplificateur à faible bruit (302) et un dispositif de transposition de fréquence équipé d'un mélangeur (304), dans lequel au moins l'un des mélangeur et amplificateur comporte un étage de transconductance conforme à la revendication 1.

**10.** Utilisation d'un étage de transconductance conforme à la revendication 1 dans un téléphone portable.

**Fig. 1**

**Fig. 2**

**Fig. 3A**

**Fig. 3B**

Fig. 4

Fig. 5

Fig. 6

Fig. 7

Fig. 8

Fig. 9A

Fig. 9B

**Office européen des brevets**

# RAPPORT DE RECHERCHE EUROPEENNE

Numéro de la demande

EP 02 29 0982

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | US 5 903 185 A (CARGILL ROBERT S) 11 mai 1999 (1999-05-11) * colonne 2, ligne 32 - colonne 4, ligne 48; figures 3-5 * | 1,2,5 | H03F1/32 |
| A | US 4 247 825 A (BERGER HERMANN) 27 janvier 1981 (1981-01-27) * colonne 2, ligne 24 - colonne 5, ligne 29; figures 1-4 * | 1,2,5 | |
| A | P.R. GRAY ET AL: "ANALYSIS AND DESIGN OF ANALOG INTEGRATED CIRCUITS    Fourth Edition" mars 2001 (2001-03) , JOHN WILEY & SONS, INC , USA XP002207514  269560 * page 215, alinéa 3.5 - page 221, ligne 12; figures 3.48-3.51 * | 1,2 | |

DOMAINES TECHNIQUES RECHERCHES (Int.Cl.7)

H03F

Le présent rapport a été établi pour toutes les revendications

| Lieu de la recherche | Date d'achèvement de la recherche | Examinateur |
|---|---|---|
| LA HAYE | 25 juillet 2002 | Tyberghien, G |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**    EP 02 29 0982

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

25-07-2002

| Document brevet cité au rapport de recherche | | Date de publication | Membre(s) de la famille de brevet(s) | | Date de publication |
|---|---|---|---|---|---|
| US 5903185 | A | 11-05-1999 | EP | 0944954 A1 | 29-09-1999 |
| | | | JP | 2001508610 T | 26-06-2001 |
| | | | WO | 9828841 A1 | 02-07-1998 |
| US 4247825 | A | 27-01-1981 | DE | 2810167 A1 | 13-09-1979 |
| | | | CA | 1138052 A1 | 21-12-1982 |
| | | | FR | 2419611 A1 | 05-10-1979 |
| | | | GB | 2016235 A ,B | 19-09-1979 |
| | | | IT | 1111148 B | 13-01-1986 |
| | | | JP | 1373251 C | 07-04-1987 |
| | | | JP | 54124957 A | 28-09-1979 |
| | | | JP | 61036408 B | 18-08-1986 |

EPO FORM P0460

Pour tout renseignement concernant cette annexe : voir Journal Officiel de l'Office européen des brevets, No.12/82